# EUROPEAN PATENT APPLICATION

(11) **EP 3 893 274 A1**
(43) Date of publication of application: **13.10.2021**
(21) Application number: 20168470.1
(22) Date of filing: 07.04.2020
(51) Int. Cl.: H01L 23/427, F28D 15/02

(54) **COOLING ELEMENT AND METHOD OF MANUFACTURING A COOLING ELEMENT**

(71) Applicant: ABB Schweiz AG, 5400 Baden (CH)
(72) Inventor: Manninen, Jorma, 00380 Helsinki (FI); Silvennoinen, Mika, 00380 Helsinki (FI); Pakarinen, Joni, 00980 Helsinki (FI)
(74) Representative: Kolster Oy Ab

(57) **Abstract**

A cooling element and a method of manufacturing a cooling element. The cooling element comprises a body having a surface adapted to receive a heat source, wherein the body is formed of extrusion profile having open ends. The cooling element further comprises plugs attached to the open ends of the body to close the body, and a port for filling working fluid inside the closed body.

## Description

### FIELD OF THE INVENTION

The present invention relates to a cooling element, and particularly to cooling element for high powered electrical components.

### BACKGROUND OF THE INVENTION

Power electronic switch components or power electronic switch modules require cooling when operated. The cooling is typically produced by attaching the components or modules to a heat sink or to a cooling element. The losses from the heat source are led to a surface of a cooling element. The heat source, such as a power electronic module, is attached firmly to the surface of the cooling element. The cooling element transfers the heat away from the heat source and further to external cooling fluid, such as air or liquid.

There are various types of cooling elements. Cooling elements can be formed of a block of metal, such as aluminium or copper, with cooling ribs, for example. The metal block acts as a sink for the generated heat and the heat is transferred to a large mass. The heat from the metal block is further transferred to a surrounding medium using the cooling ribs which increase the surface area of the cooling element.

In certain applications use of metal blocks as cooling element does not give satisfying results. More effective heat transfer can be obtained by using cooling element designs having phase-changing liquids. Heat from the heat source, such as power electronic module, heats a liquid held inside the cooling element. The liquid in a closed volume evaporates from the heat, and transfers the heat effectively to a cooler place inside the closed volume. The vapour condenses in the cooler place and loses heat. Cooling elements based on phase-changing properties are more effective than the conventional metal-blocks. However, the more effective cooling elements are also more complicated and therefore more expensive to produce.

### BRIEF DESCRIPTION OF THE INVENTION

An object of the present invention is to provide a cooling element and a method of manufacturing a cooling element so as to alleviate the above disadvantage. The object of the invention is achieved by a cooling element and a method which are characterized by what is stated in the independent claims. The preferred embodiments of the invention are disclosed in the dependent claims.

The invention is based on the idea of using metal extrusion profile in forming of a cooling element. The extrusion profile is hollow and has two open ends. The ends are closed with suitable structures and thereby a hollow closed volume structure is obtained. The cooling element is further provided with a port for filling working fluid inside the closed structure. In the cooling element of an embodiment, an insert is provided inside the hollow structure to provide capillary wick function which ensures proper phase-change operation.

An advantage of the invention is that an effective cooling element is obtained with a simple structure. As the cooling element is produced of an extruded profile, the size of the cooling element can be easily changed by using profiles of different lengths.

### BRIEF DESCRIPTION OF THE DRAWINGS

In the following the invention will be described in greater detail by means of preferred embodiments with reference to the accompanying drawings, in which
Figure 1 shows a front view of a cooling element of an embodiment,
Figure 2 shows a side view of the cooling element of Figure 1; and
Figures 3, 4, 5, 6, 7 and 8 show embodiments of the cooling element.

### DETAILED DESCRIPTION OF THE INVENTION

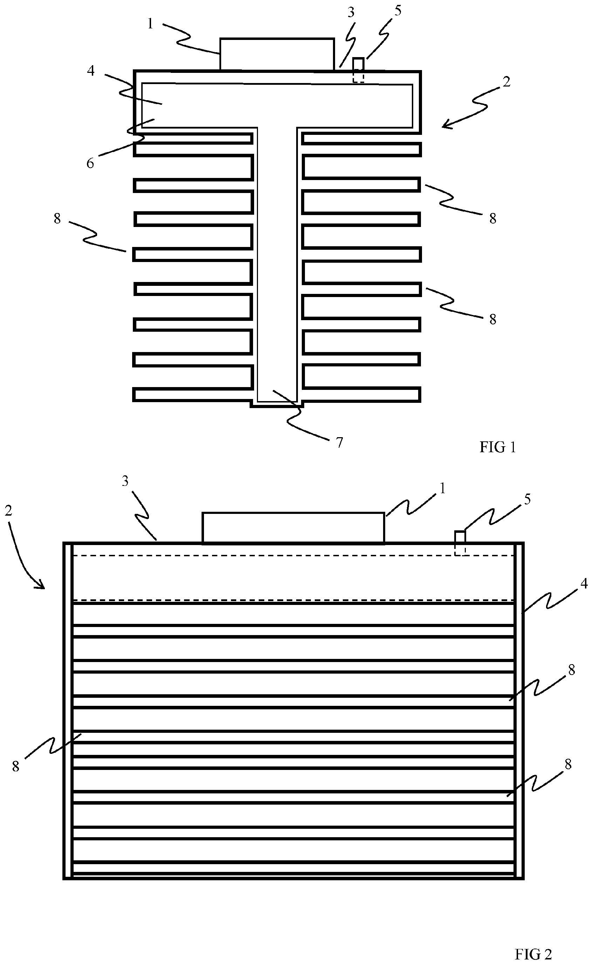

Figure 1 shows a front view of an embodiment of a cooling element of the invention. As known, cooling element is intended to be mechanically connected to a heat source, such as a power electronic switch component or a power electronic switch module which houses multiple of switch components. In Figure 1 a heat source 1 is shown to be attached to a surface of the cooling element 2. According to the invention, the cooling element 2 comprises a body having a surface 3 adapted to receive a heat source 1. As shown in Figure 1, the surface which is adapted to receive a heat source is substantially even surface such that the heat transfer from the heat source to the cooling element is as efficient as possible.

In the present invention, the body of the cooling element is formed of extrusion profile having open ends. Figure 1 shows a front view of the cooling element. The front view refers to a view which is in a direction of the extrusion. As it is understood, the opening extends through the profile as the body is an extruded structure.

The cooling element of the invention comprises further plugs 4 attached to the open ends of the body to close the body. The plugs 4 of the cooling element are elements which are fastened to the open ends of the profile such that the ends are closed and an air-tight hollow structure is formed inside the cooling element.

Figure 1 shows a plug 4 which is fastened to one end of the extruded profile. In the structure of Figure 1 the plugs are generally T-shaped and they cover the openings of the ends of the profile.

Further according to the invention, the cooling element comprises also a port 5 for filling working fluid inside the closed body. The port is generally a closable opening which is made to the body of the cooling element. The opening extends through the body to the hollow interior of the body such that working fluid can be inserted inside the structure. Ideally, after fluid filling the opening is sealed in a way that there are not structures that extend from the cooling element surface. This makes it less vulnerable for failures.

The working fluid inside the structure refers to a fluid which evaporates due to heat from a heat source which is attached to a surface of the cooling element. The working fluid further condenses inside the hollow structure. With the two-phase operation of the working fluid an effective cooling element is formed. The heat source is attached to horizontally oriented part of the T-shaped profile. This part acts as an evaporator 6. The evaporated fluid seeks its way to cooler places and condenses. The vertically oriented part of the T-shaped profile acts as a condenser 7.

As shown in Figure 1, the cooling element comprises also cooling fins 8. The fins are formed by extruding at the same time as the body of the cooling element. Thus the cooling fins 8 are a part of the extruded profile. As the cooling fins are integral part of the profile, the heat transfer from the body to the cooling fins is efficient.

Figure 2 shows a side view of the cooling element of Figure 1. As the body of the cooling element is extruded, the structures of the body extend in the form of the profile.

According to an embodiment, the inner surface of the body is machined to increase the fluid circulation. The machined inner surface, i.e. the surface of the closed cavity, may comprise grooves. The machined inner surface may also be treated to increase the roughness of the surface.

According to another embodiment, the plugs used for closing the ends of the body comprise surface treatment to increase the fluid circulation. As is understood, the surface of the plugs which are facing towards the body and form inner surface of the cavity are treated to increase the fluid circulation. The treatment applied to the surfaces may also include additional structures, such as wick, to increase the fluid circulation.

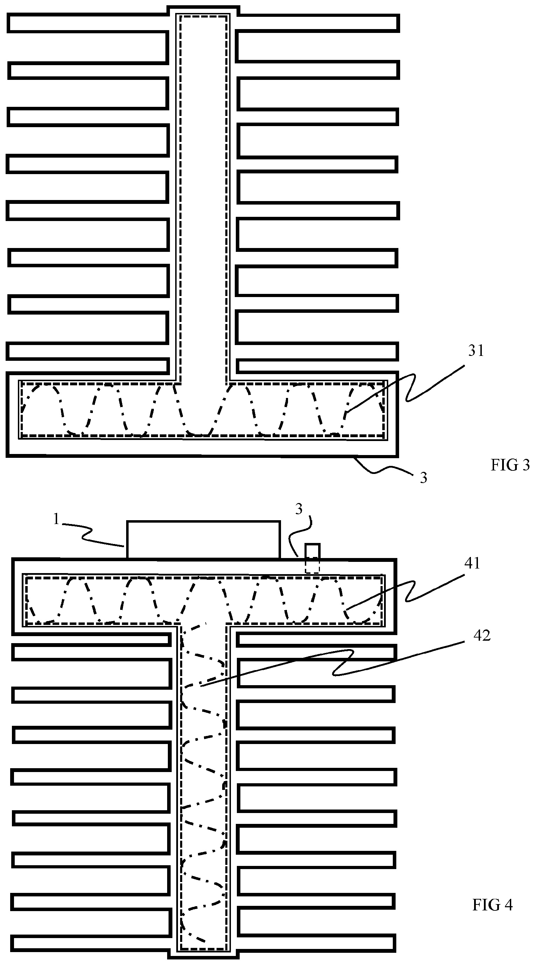

According to another embodiment, the cooling element comprises an insert arranged inside the body. Figure 3 shows a cross section of an embodiment of the invention in which an insert 31 is inserted inside the body of the cooling element. In the cross-section the internal structure of the formed cavity is shown. The insert 31 is arranged in the cavity in which the working fluid is also arranged. The purpose of the insert is to increase the fluid circulation and thereby to increase the cooling properties. The insert may also improve heat sink's performance in terms of higher heat flux, total wattage, and larger freedom in operation orientation of the cooling element. The insert may provide improved working fluid transfer properties to the cooling element. In the embodiment, the insert 31 is shown as a wavy structure which is held in place for example by tension force of the structure. In Figure 3 the insert is shown only in the evaporator part of the cooling element. In the embodiment of Figure 4, the inserts are situated both in the evaporator part 41 and in the condenser part 42. It is to be understood, that the inserts 31, 41, 42 may extend in the whole length of the structure. The length refers here to the length of the profile in the direction of the extrusion.

The insert parts may be manufactured in several ways. They may for example consist of metal wires and wire mesh parts that may be inserted inside extrusion profile. The inserts may be porous sintered metal powder parts, solid metal alloy pieces and plates, die-cut and punched sheet metal alloy parts that have been formed into preferred shapes, and different metal alloys with spring and/or sponge-like features. A part or several of them with above-mentioned properties may also be made of carbon materials like graphite and graphene, polymers, polymer composite materials, and ceramics.

The insert part or several of them are not required in the cooling element, and their need depends on e.g. working fluid selection, total heat loss (Watts) and heat flux (W/cm2) level, operating orientation, ambient temperature range, and other design features. However, these inner capillary structures (i.e. parts) may improve heat sink's performance in terms of higher heat flux, total wattage, and larger freedom in operation orientation. This applies also to the plug-parts' surface that is in contact with forking fluid. There may also be surface treatment or additional parts attached to the plug-part's surface to enhance heat sink performance.

The insert parts can be secured or fixed into the extrusion profile with several techniques like with soldering or using tension force i.e. the insert part is compressed slightly while assembling it into the extrusion part.

According to an embodiment of the invention, the body of the cooling element is of extruded aluminium. According to another embodiment, the body of the cooling element is of extruded copper or steel.

As known, water is high performing working fluid for two-phase heat transfer and commonly used with copper-based cooling systems. However, water reacts with aluminium and produces hydrogen gas which results in two-phase heat transfer failure. Thus, for example acetone, ethanol, methanol or R1233zd refrigerant could be used in aluminium heat exchanger. However, according to an embodiment, surfaces of separate parts of aluminium cooling element (extrusion part, the plugs, the insert parts) are treated with specific materials before or after the heat exchanger final assembly. One suitable material for treating the aluminium parts is nickel. This treatment may enable the use of various working fluids e.g. water.

According to the method of the present invention, the method of manufacturing of a cooling element comprising a body having a surface comprises providing an extrusion profile having open ends, attaching plugs to the open ends of the body to close the body, and providing a port for filling working fluid inside the closed body.

In the method, a suitable piece of extruded metal is provided. The profile, i.e. the continuous cross-section of the structure is designed to have desired properties. The extruded metal, such as aluminium or copper, is cut to desired length. According to an embodiment, insert pieces are arranged inside the hollow extruded piece. Further, the inner surface of the extruded piece may be processed by coating the surface and/or machining the inner surface to provide enhanced properties relating to cooling performance.

Further, the plugs are attached to the open ends of the body. When the plugs are attached, a closed structure is formed and the structure has a cavity. A port for filling working fluid inside the closed body is provided to the body. When working fluid is inserted inside the closed body that is also vacuumed, the cooling element can be employed in two-phase cooling operation.

According to an embodiment of the invention, prior to closing the extruded body, an insert is inserted inside the body. Further, the number of inserts is not limited to one, but can vary according to design of the cooling element and according to desired properties. Some applications may not require insert but surface treatments may provide sufficient cooling performance.

In manufacturing of cooling element of the invention, conventional manufacturing techniques apply and can be used for production. Aluminium extrusion process is very suitable for mass production and cost effective.

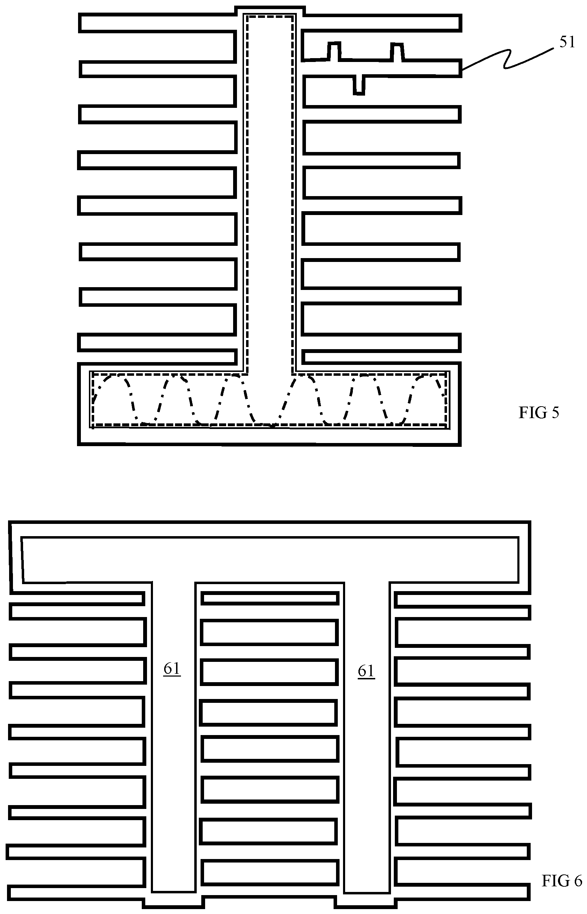

The aluminium extrusion profile can easily contain several condenser parts. Figure 6 shows a cooling element with two condenser parts 61. The cooling element length in the direction of extrusion is practically unlimited. Thus, cooling elements of different length can be produced from the same baseline extrusion profile easily.

The examples shown in the drawings show structures in which the working fluid spaces inside the cooling elements are rectangular. However, the shape of the fluid space is not limited to rectangular shapes. The cross-section of the profile may have various shapes which enable to use the shape as a design option. The cooling fins which are extending from the outer surface of the cooling element may also have various and complex shapes. The fins are not even necessary straight. The contact between the cooling fins and the condenser surface is ideal as there are no boundaries between the two. Figure 5 shows another example of a cooling element. In the cooling element the shape of one cooling fin 51 is shown to differ from the other cooling fins. Figure 5 is to illustrate the possibilities which are achieved when the cooling fins are extruded together with the body of the cooling element is extruded.

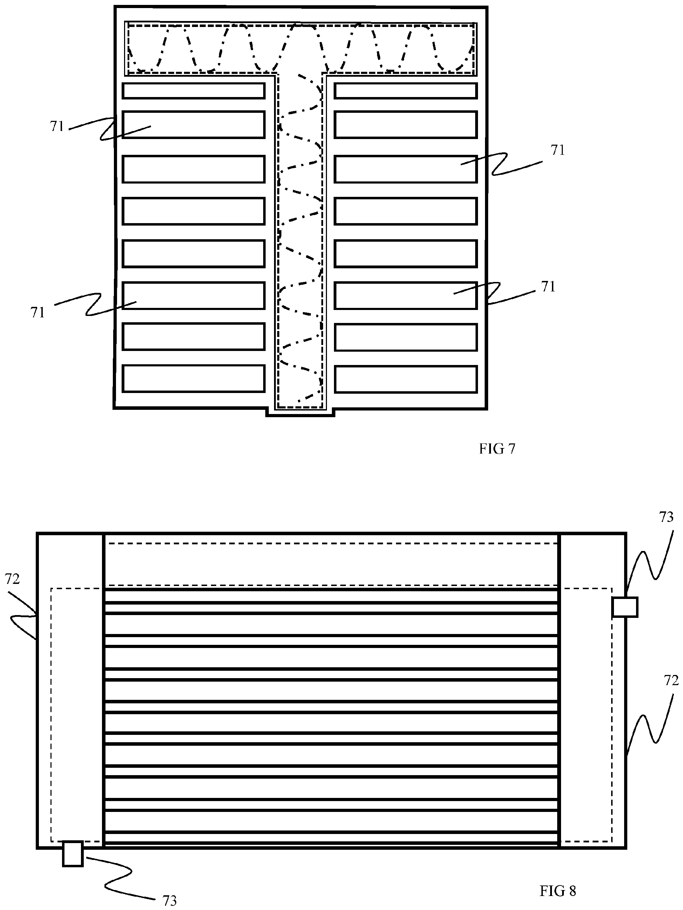

Figures 7 and 8 show another embodiment of the invention. Figure 7 shows the structure as seen from the ends of the extruded profile and Figure 8 shows a side view of the cooling element. In the embodiment channels 71 for liquid cooling are provided in the extruded cooling element. More particularly the body comprises liquid cooling channels 71 which are extruded. The cooling element comprises liquid manifolds 72 attached to open ends of the body as shown in Figure 8. The liquid manifolds have liquid ports 73 for allowing liquid circulation through the liquid cooling channels.

In the embodiment, a liquid circulation is added to increase the removal of heat from the cooling element. As the liquid cooling channels are next to each cooling fin, the liquid circulation removes heat effectively from the cooling fins. The liquid manifolds are structures which enable the cooling liquid to be passed from a liquid port to the liquid cooling channels and from the liquid cooling channels to another liquid port. The manifolds can be attached to the ends of the profile using commonly available fastening techniques.

In the example of Figures 7 and 8 the cooling element has the basic structure of the example of Figure 4 having inserts inside the body. In the embodiment with the manifolds, it is also possible to provide the port for filling working fluid inside the manifolds. When placed inside the manifolds, the port is not visible and not vulnerable to mechanical impacts.

When liquid cooling channels are produced in the extruded profile, the cooling fins extending from the body are attached to each other in their distant ends. As the ends are attached, closed channels are formed in the extruded structure.

In the above the cooling element of the invention is described together with some of the embodiments of the invention. The various features of the embodiments can also be combined. For example, the inner surface of the cavity may have a treatment for enabling to use different fluids and at the same time the cooling element may have inserts inside the structure to enhance the fluid circulation.

It will be obvious to a person skilled in the art that, as the technology advances, the inventive concept can be implemented in various ways. The invention and its embodiments are not limited to the examples described above but may vary within the scope of the claims.

## Claims

1. A cooling element comprising a body having a surface adapted to receive a heat source, wherein the body is formed of extrusion profile having open ends, and the cooling element further comprises
plugs attached to the open ends of the body to close the body, and
a port for filling working fluid inside the closed body.

2. A cooling element according to claim 1, wherein the cooling element further comprises one or more inserts arranged inside the body.

3. A cooling element according to claim 2, wherein the one or more inserts are arranged to provide capillary properties inside the body or enhance the fluid circulation inside the body.

4. A cooling element according to claim 1, 2 or 3, wherein an inner surface of the closed body comprises surface treatment.

5. A cooling element according to claim 4, wherein the surface treatment is a machined surface or a coating.

6. A cooling element according to claim 5, wherein the coating is a nickel coating.

7. A cooling element according to any one of claims 1 to 6, wherein one or more inserts are attached to a plug such that when plug is attached to an open end of the body, the one or more inserts are inside the closed body.

8. A cooling element according to any one of claims 1 to 7, wherein the working fluid is water, acetone, ethanol, methanol or R1233zd refrigerant.

9. A cooling element according to any one of claims 1 to 8, wherein the body is formed of extruded aluminium, extruded copper or extruded steel.

10. A cooling element according to any one of claims 1 to 9, wherein the body further comprises liquid cooling channels, and the cooling element further comprises liquid manifolds attached to open ends of the body, the liquid manifolds having liquid ports for allowing liquid circulation through the liquid cooling channels.

11. A method of manufacturing a cooling element comprising a body having a surface comprises
providing an extrusion profile having open ends,
attaching plugs to the open ends of the body to close the body, and providing a port for filling working fluid inside the closed body.

12. A method according to claim 11, wherein the method further comprises filling working fluid inside the closed body.

13. A method according to claim 11 or 12, wherein the method comprises inserting inserts inside the body prior to attaching the plugs to the open ends of the body.
